# EUROPEAN PATENT APPLICATION

(11) **EP 0 786 815 A1**
(43) Date of publication of application: **30.07.1997**
(21) Application number: 96119894.2
(22) Date of filing: 11.12.1996
(51) Int. Cl.: H01L 27/14, H04N 5/335, G02B 27/00

(54) **Photosensor array with compensation for optical aberrations and illumination nonuniformity**

(30) Priority: 26.01.1996 US 592085
(71) Applicant: Hewlett-Packard Company, Palo Alto, California 94304 (US)
(72) Inventor: Steinle, Michael J., Fort Collins, CO 80525 (US); Meyer, Gerald L., Fort Collins, CO 80525 (US)
(74) Representative: Schoppe, Fritz, Dipl.-Ing.

(57) **Abstract**

A photosensor array (600, 602, 604, 700, 702, 704, 800, 802, 804, 1006) in which the geometry of the array provides compensation for aberrations and non-uniformities in an associated optical system (200, 300, 400), including compensation for distortion, chromatic difference of magnification, non-uniform light transmission/reflection/absorption/illumination, field curvature and longitudinal (axial) chromatic aberration. To compensate for distortion, sensor elements (602, 604) are placed along curves rather than being placed linearly. To compensate for lateral color (chromatic difference of magnification), sensor element (700, 702, 704) spacing is made non-uniform. To compensate for non-uniform light transmission/reflection/absorption/illumination, sensor element (800, 802, 804) area is made non-uniform. Finally, to compensate for field curvature and longitudinal (or axial) chromatic aberration, sensor elements are made non-planar (904). Example embodiments are given for line arrays and for matrix arrays (1006).

## Description

### FIELD OF INVENTION

This invention relates generally to color photosensor arrays and more specifically to changing the photosensor array design to compensate for optical aberrations and illumination nonuniformity.

### BACKGROUND OF THE INVENTION

Image scanners, video cameras, digital cameras and some types of copying machines use optical systems to form an image onto an array of photosensitive elements. The photosensor array and associated electronics convert light into electronic signals that are then digitized and converted into a format suitable for recording, digital transmission to a computer, or printing. In some imaging systems, light from an image passes through a beam splitter or a filter arrangement so that each photosensitive element receives light having a relatively narrow band of wavelengths. In other imaging systems, light from an image is sequentially filtered so that each photosensitive element first receives light of one color, then light of another color and so forth.

Many of the equations used for design of optical systems are accurate only for a region very close to the optical axis, called the paraxial region. In general, optical systems have various aberrations causing some light rays to diverge from the idealized paraxial equations. These aberrations include, for example, spherical aberration, astigmatism, coma, field curvature, distortion, chromatic aberration, and lateral color. These aberrations are not restricted to just lenses, but instead may result from minors, color separators, filters, glass plates or any other light refracting, reflecting or transmitting elements. Typically, corrections for optical aberrations are made within the optical system. For example, spherical aberration may be improved by a doublet, a positive and a negative lens cemented together. Similarly, doublets of optical elements having opposite signs of chromatic aberration can partially correct chromatic aberration.

There is a need for improved resolution and accuracy of electronic imaging, creating a corresponding need for improved correction of aberrations in the optical systems forming images on the sensor arrays. There is also a general need for compensation for non-uniform transmission, reflection and absorption of light and compensation for non-uniform illumination. In addition, there is a general need for reducing cost, size and complexity of systems used in electronic imaging.

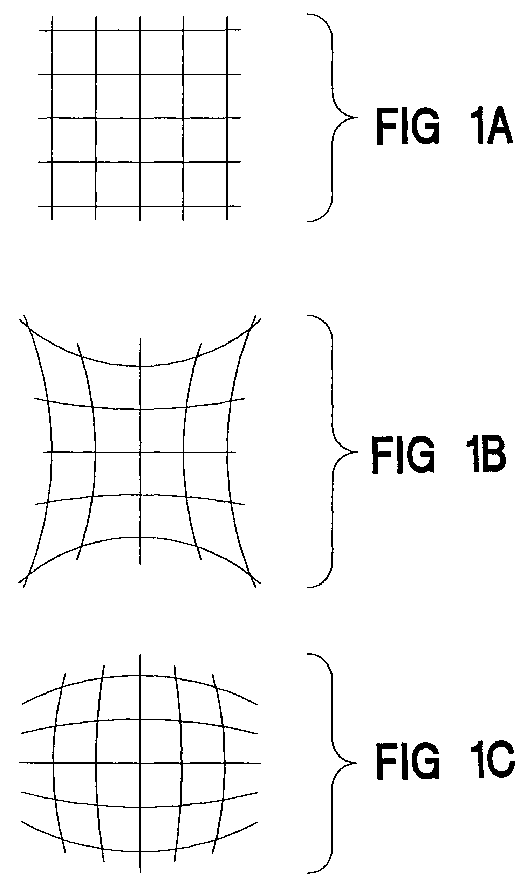

There are three optical aberrations of particular interest in the invention. The first is distortion, where the image of an off-axis point on the image plane is farther from the axis or nearer to the axis than the ideal location. Figures 1A - 1C illustrate two types of distortion. Figure 1A illustrates an image comprising a grid of identical squares. Figure 1B illustrates the grid of figure 1A as imaged by a lens having off-axis points nearer to the axis than the ideal locations, resulting in an image having concave sides (pincushion distortion). Figure 1C illustrates the grid of figure 1A as imaged by a lens having off-axis points farther from the axis than the ideal locations, resulting in an image having convex sides (barrel distortion).

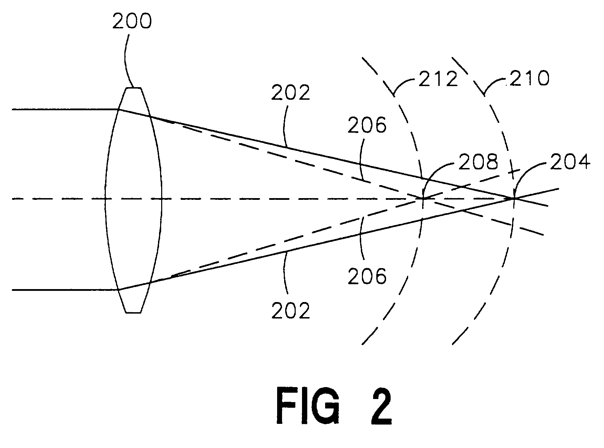

Figure 2 illustrates the second aberration of particular interest, which is actually several separate aberrations that will be lumped together for purposes of the present application. The separate aberrations all involve focal surfaces. For any lens, off-axis images seldom lie in a plane. The term "astigmatism" is used to describe an effect where light rays in a first plane (tangential plane) focus at a different distance from the lens than light rays in a second plane (sagittal plane) that is perpendicular to the first plane. Even in the absence of astigmatism, there is a tendency for the focal surface to be non-planar. The general effect is called field curvature. In addition, the focal surface is different for each wavelength. The term "longitudinal (or axial) chromatic aberration" is used to describe the condition where the rear focal point (surface) is dependent on wavelength. In general, the index of refraction of optical materials is higher for shorter wavelengths than for longer wavelengths, resulting in shorter wavelengths being focused closer to the lens than the longer wavelengths. In figure 2, a lens 200 refracts first light rays 202 having a first wavelength (for example, red) at an angle such that the first light rays 202 come to a focus at point 204. Light rays 206, having a shorter wavelength (for example, blue) than light rays 202, come to a focus at point 208 that is closer to the lens 200. Focal points 204 and 208 are on the optical axis. Because of field curvature, focal points for red light off the optical axis lay along a non-planar surface 210. Likewise, focal points for blue light lay along a different non-planar surface 212.

One approach to improvement of longitudinal (or axial) chromatic aberration is to provide three separate sensor assemblies, each at a slightly different focal distance. This approach requires precise alignment and mounting of the separate assemblies. An alternative approach is taught in U.S. Patent Number 5,040,872 (Steinle '872). In one embodiment in Steinle '872, an additional transparent plate having multiple non-planer (stepped) surfaces is placed in the light path such that each color passes through a slightly different thickness of the additional transparent plate.

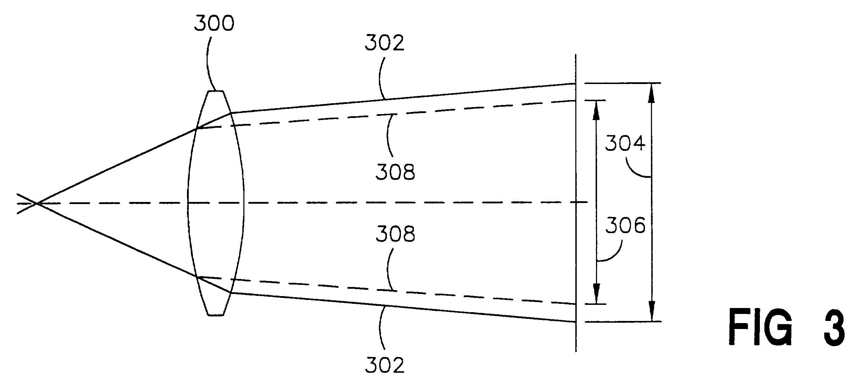

Figure 3 illustrates the third aberration of particular interest; lateral color (or chromatic difference of magnification), where magnification is dependent on wavelength. Because shorter wavelengths are refracted more than longer wavelengths, shorter wavelengths are bent more towards the axis, resulting in less magnification for shorter wavelengths than for longer wavelengths. In figure 3, lens 300 refracts light rays 302 of a first wavelength (for example, red) resulting in a first image height 304. The lens 300 refracts light rays 308 having a shorter wavelength (for example, blue) resulting in a second image height 306 that is smaller than the first image height 304.

One approach to improvement of lateral color (or chromatic difference of magnification) is taught in U.S. Patent Number 5,406,066 (Steinle '066). In Steinle '066, a beam splitter divides the light into three color bands (red, green, blue). The photosensor array has three linear rows of charge coupled device (CCD) elements, each row receiving a line image having one color. In one embodiment taught by Steinle '066, the length of the CCD elements within a row is proportional to the magnification for the corresponding color for that row. As a result, the overall length of each row is variable, depending on the length of the individual CCD elements within that row. In a commercially available three line CCD array, the light sensitive area of each element is uniform but the spacing between CCD elements within a row is proportional to the magnification for the corresponding row, resulting in the overall length of each row being variable as in Steinle '066.

Still another imaging system imperfection of interest involves light intensity variation. Again, several non-uniformities will be lumped together for purposes of the present application. The first light intensity non-uniformity of interest includes non-uniform transmission (lenses), reflection (mirrors) or absorption (filters). In general, for a lens, the transmissivity for off-axis image points is lower than the transmissivity for a point on the axis. One transmissivity fall-off effect is commonly called vignetting. A collection of additional transmissivity fall-off effects are commonly grouped into one equation called the "cosine fourth law." The second light intensity non-uniformity of interest involves non-uniform illumination. Scanners, copiers and other imaging systems may have an internal light source. The light source may be non-uniform. For example, an elongated fluorescent lamp is typically brighter in the center of the lamp than at the ends. In one prior art technique for compensation for light non-uniformity for a fluorescent lamp, an aperture is placed in the light path, the aperture having a shape passing more light through the ends of the aperture than for the center of the aperture. Additional compensation is provided electronically and in software using calibration image areas having a known uniform intensity.

Light Emitting Diodes (LED's) may also be used for illumination. A linear array of LED's typically exhibits a peak intensity near the center of each LED with lower intensity in the regions between LED's. A typical approach to reducing the light intensity variation for LED's is to add a light diffuser, either transmitting or reflecting.

Note that in the figures discussed above, lenses are used to illustrate the various aberrations. In general, equivalent aberrations may also occur with reflective surfaces instead of transmissive surfaces. In this application, "optical system" is intended to include lenses, mirrors, filters, apertures, color separators and anything else affecting light rays involved in creating an image onto the surface of a sensor array.

### SUMMARY OF THE INVENTION

The primary goal of the invention is to reduce the size, cost, weight and complexity of the optical system by compensating for optical aberrations and non-uniform light transmission/reflection/absorption/illumination (TRAI) through relatively simple and low cost changes to the sensor array rather than through compensation within the optical system. The array is three dimensional (X,Y,Z). To compensate for Y dimension distortion, sensor elements are placed along curves rather than being placed linearly. To compensate for X dimension distortion and lateral color (chromatic difference of magnification), the spacing in the X dimension of the active areas of sensor elements is made non-uniform. To compensate for non-uniform light TRAI, sensor element active area is made non-uniform. Finally, to compensate for field curvature and longitudinal (or axial) chromatic aberration, sensor elements are made non-planar in the Z dimension. The changes to the sensor array enable the optical system to use fewer, less precise and less complex optical elements, thereby reducing overall size and weight. In addition, the changes to the sensor array involve automated processes that are common in integrated circuit processing. Given sufficient volume, the changes to the sensor array may be inexpensive relative to the costs of optical elements. Example embodiments are given for line arrays and for matrix arrays.

### BRIEF DESCRIPTION OF THE DRAWINGS

Figure 1A is a plane view of an image of a symmetrical grid.

Figure 1B is a plane view of the grid of figure 1A as distorted by a lens having pincushion distortion.

Figure 1C is a plane view of the grid of figure 1A as distorted by a lens having barrel distortion.

Figure 2 is a side view of an optical system illustrating longitudinal (or axial) chromatic aberration and field curvature.

Figure 3 is a side view of an optical system illustrating lateral color (or chromatic difference of magnification).

Figure 4 is a perspective view of a single lens imaging three lines onto a three-line photosensitive array.

Figure 5 is a plane view of a prior art three-line photosensitive array.

Figure 6 is a plane view of a photosensitive array having compensation for Y dimension aberrations in accordance with the invention.

Figure 7 is a plane view of part of the photosensitive array of figure 6 having additional compensation for X dimension aberrations.

Figure 8 is plane view of part of the photosensitive array of figure 6 having additional compensation for non-uniform TRAI.

Figure 9 is a cut away side view of part of the photosensitive array of figure 6 having additional compensation for Z dimension aberrations.

Figure 10 is a plane view of a photosensitive matrix array.

### DETAILED DESCRIPTION OF THE PREFERRED EMBODIMENT OF THE INVENTION

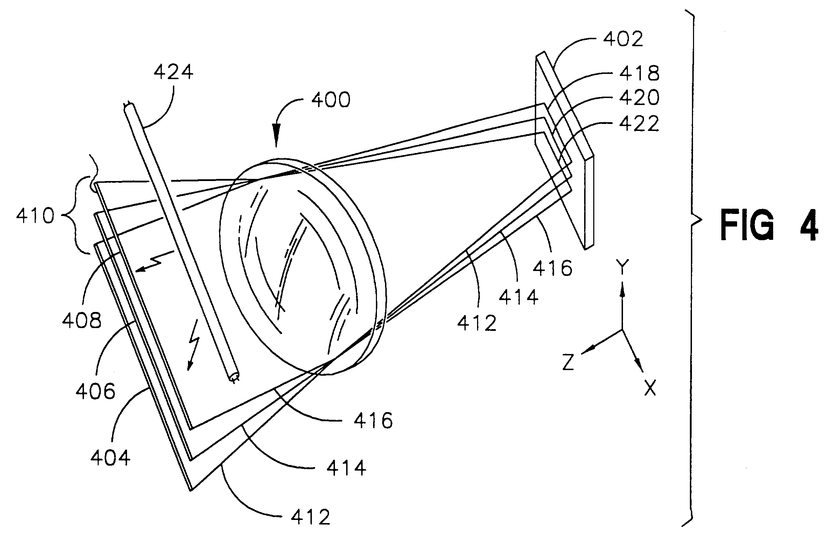

Figure 4 illustrates an optical system, depicted as a single lens 400, and a photosensor assembly 402. Three spaced-apart scan line portions (404, 406 and 408) of an image 410 are imaged via light rays 412, 414 and 416 onto three linear arrays (418, 420 and 422) on the photosensor assembly 402. A photosensor assembly having multiple linear rows as depicted in figure 4 is typical of photosensor assemblies used in some color scanners and some color copying machines. Optics systems for scanners and copiers are typically much more complex than a single lens. Also illustrated in figure 4 is a lamp 424. For copiers and scanners of opaque images, light from lamp 424 is reflected from the image 410. For transparent images, the lamp 424 may be on the back side of the image 410 or light may be reflected through the back side so that light from the lamp 424 passes through the back side of the image 410 and then on to the photosensor assembly 402.

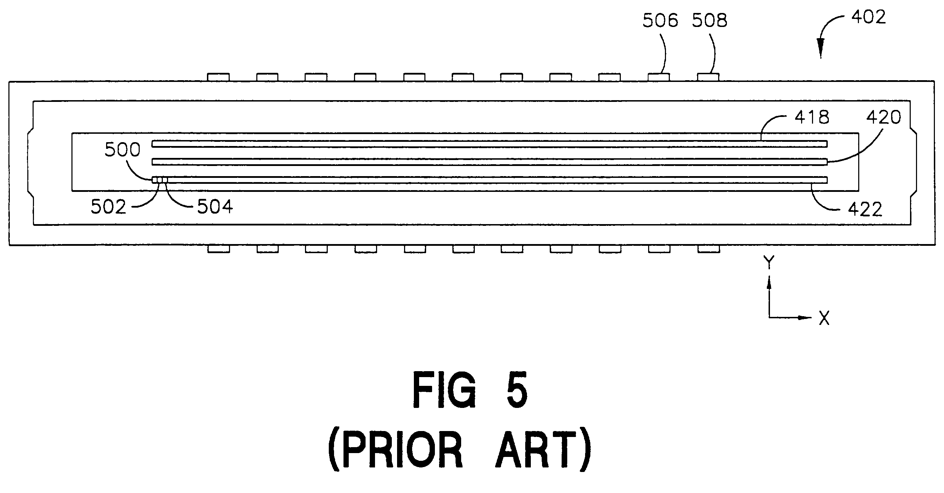

Figure 5 is a plane view of the photosensor assembly 402 of figure 4. Each row (418, 420, 422) further comprises many individual photosensitive elements, depicted as elements 500, 502 and 504 for row 422. Each photosensitive element converts light into an electronic signal representative of the light intensity impinging on the element. Electronic contacts (506, 508) provide electrical connection to additional electronics for signal processing, storage or printing. Each row (418, 420 422) receives a separate color band of light. In alternative configurations, one row may receive unfiltered light and two rows may be filtered, or there may be four rows, one receiving unfiltered light. Each individual row may have a color filter (not illustrated) as part of the photosensor assembly. Alternatively, a beam splitter or other color separation device (not illustrated) may divide light from an image into three color bands (typically, red, green and blue) before the light reaches the photosensor assembly. For the invention, it does not matter where color separation or filtering occurs.

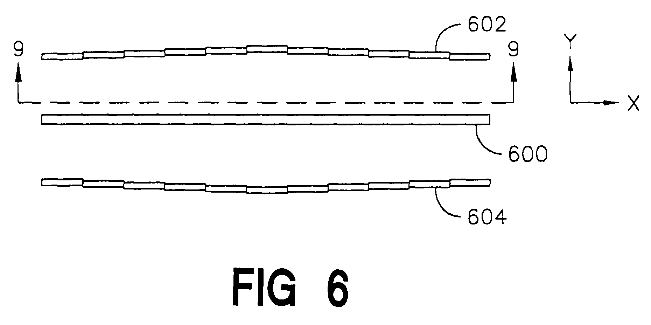

Figure 6 illustrates a three row (600, 602, 604) sensor assembly in accordance with the invention in which two rows (602 and 604) are curved to compensate for combined aberrations in the Y dimension. A center row 600 is at the centerline (optical axis) for the Y dimension and needs no Y dimension compensation. Note that sensor assembly in figure 6 illustrates compensation for barrel distortion but Y dimension positions of individual sensor elements may be similarly adjusted to compensate for any Y dimension aberration, including pincushion distortion or a combination of distortion and lateral color (or chromatic difference of magnification).

Sensor arrays are typically fabricated using optical lithography. The lithography system has a minimum incremental step size. In figure 6, for rows 602 and 604, the spacing of each individual sensor element in the Y dimension relative to the centerline of row 600 is matched to the distortion of an associated optical system (not illustrated) rounded to the nearest discrete step of the lithography system. In general, rows 602 and 604 will not be symmetrical about the X axis since each row senses a different color and distortion is color dependent.

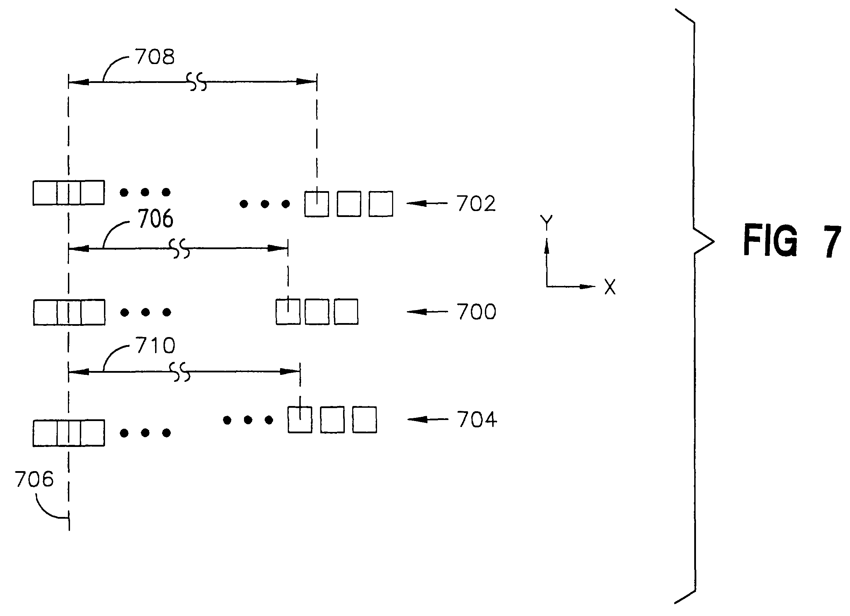

Figure 7 illustrates some of the sensor elements of figure 6 with additional compensation for aberration in the X dimension, including distortion and lateral color (or chromatic difference of magnification). In one embodiment in Steinle '066, sensor element size is adjusted to compensate for lateral color. In figure 7, pixel spacing in the X dimension is adjusted to compensate for distortion, lateral color and other X dimension aberrations. Near the X centerline 706, the spacing of sensor elements is minimized to maximize resolution. As the distance increases from the X centerline, the position of each individual sensor element is determined by the amount of combined distortion and lateral color aberration for the particular color, again rounded to the nearest discrete step of the lithography system.

In general, the X dimension spacing of elements for each row will be different, depending on the color associated with each row. Stated alternatively, sensor elements sensing light rays from a vertical line in the original image will not be placed along a vertical line in the array. For example, in figure 7, the top row 702 might be designed to receive red light. A particular sensor element is distance 708 from the X centerline. Row 704 might be designed to receive green light. Recall from figure 3 that shorter wavelengths are refracted more than longer wavelengths. As depicted in figure 7, a sensor element corresponding to the particular sensor element of row 702 is distance 710 from the X centerline. Distance 710 is less than distance 708. Finally, row 700 might be designed to receive blue light. A sensor element corresponding to the particular sensor element of row 702 is distance 706 from the X centerline. For blue light, having shorter wavelengths than red or green, distance 706 is less than distance 708 and distance 710.

For illustration of size and distance, the following dimensions are from a commercially available CCD photosensor assembly. Individual sensor elements have an active area that is approximately 7µm in the Y dimension by 5.5µm in the X dimension, with elements placed at a uniform 7µm pitch along the X dimension. In an image scanner system using that photosensor assembly, the optics system, which includes lenses, mirrors and a beam splitter, exhibits barrel distortion with worst case uncorrected color registration error in the Y dimension exceeding 3.5µm. That is, the worst case sensor elements sense a part of the original image that is offset about half a scan line in the Y dimension relative to sensor elements on the Y axis. In addition, the optics system exhibits lateral color (chromatic difference of magnification) with worst case uncorrected color registration error in the X dimension exceeding 3.5µm, about half the pitch of the sensor elements. For a particular sensor element at a worst case location, light rays impinging from a corresponding point on the original image may overlap only about one fourth of the active area of the sensor element. These registration errors may be improved by adding additional optical elements to the lens assembly. However, in the invention, compensation is implemented by changing the photosensor array as illustrated in figures 6 and 7. The minimum step size for the lithography system used to fabricate the sensor array is approximately 0.25µm. Therefore, the maximum X,Y offset of a sensor element relative to a corresponding light ray from the original image is reduced from 3.5µm in each dimension to 0.125µm in each dimension.

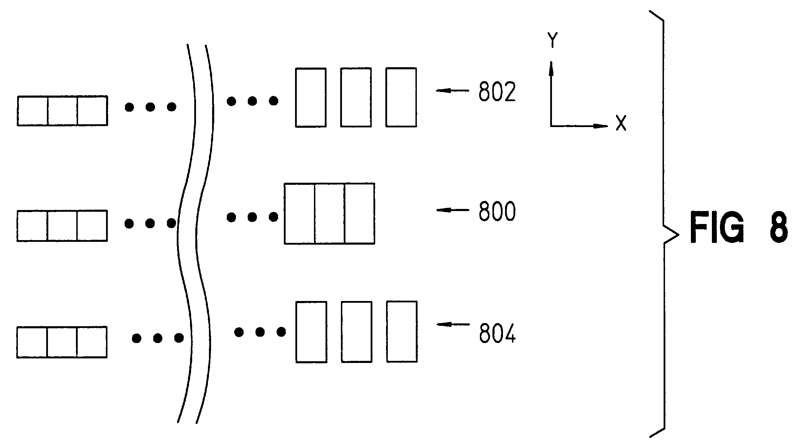

Figure 8 illustrates some of the individual sensor elements of the photosensitive assembly of figures 6 and 7 having additional compensation for non-uniform light TRAI. In the array illustrated in figure 8, variable active sensor area is used to partially compensate for for non-uniformity of light where on-axis light intensity is greater than off-axis light intensity. Note that the purpose of the sensor array is to measure variations in intensity defining an image, but the purpose of compensation is to correct for localized changes of light intensity as it passes through the optical system and to correct for non-uniform illumination. To compensate, the active area of each sensor element is dependent on the light intensity impinging on the sensor from an original image having uniform reflectance or uniform transmissivity. For example, referring back to figure 4, assuming that image lines 404, 406 and 408 have uniform reflectance or uniform transmissivity, then variations in light intensity on sensor rows 418, 420 and 422 result from non-uniform illumination from light source 424 and non-uniform transmission through the lens 400. Effectively, variable active area requires a trade-off of some resolution or measurement speed for intensity compensation. A uniform pitch may be increased to permit increased sensor element size in the X dimension, thereby sacrificing some resolution. Alternatively, the pitch may be kept minimized (and uniform) and the active area changed. This requires active areas near the centerline to be reduced in size, thereby sacrificing some measurement speed. Note, however, that prior solutions using filters or variable shaped apertures also reduce light intensity near the centerline, thereby sacrificing some measurement speed. Finally, variable area may be combined with a non-uniform pitch, with distance of a sensor element in the X dimension determined by compensation for distortion and lateral color aberrations as discussed in conjunction with figure 7. As an alternative, it may be preferable in some systems to keep spacing in the X dimension minimized and to adjust only the Y dimension of some sensor elements to partially adjust for non-uniform TRAI. This alternative slightly decreases resolution in the Y dimension for those sensor elements that are longer in the Y dimension than the minimum Y dimension size, but affects only those larger sensor elements.

Using the dimensions discussed earlier for illustration, and using a uniform minimum pitch of 7µm, the width of the active area of an element receiving minimum intensity may be 5.5µm and the width of the active area of a element receiving maximum intensity may be reduced by half to 2.25µm, providing a 2:1 range for compensation for non-uniform TRAI.

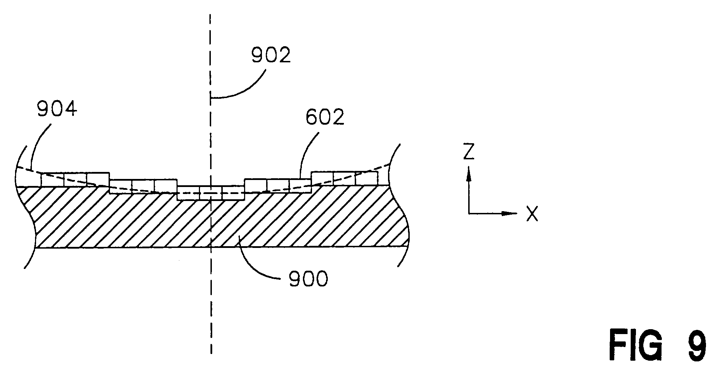

Figure 9 is a cut away side view of part of the photosensitive assembly of figure 6 having additional compensation for field curvature and longitudinal (or axial) chromatic aberration as illustrated in figure 2. Line 902 represents the optical axis of an associated optical system and the Z axis for the sensor assembly. In figure 9, row 602 of figure 6 is illustrated as individual sensor elements on the surface of a substrate 900. Note that the sensor elements are non-planar in the Z dimension, with the surface of substrate 900 having discrete steps in thickness. The discrete steps and the sensor elements lay along a curved surface 904. Curved surface 904 corresponds to surface 210 or 212 in figure 2.

Typically, sensor arrays are fabricated on silicon wafers. Epitaxial silicon may be deposited onto silicon wafers to increase thickness. Substrate steps as illustrated in figure 9 may be formed by etching away unwanted material or by selectively depositing additional material to match the focal surfaces. Etching may be preferable since selective deposition may also require mechanical polishing to achieve accurate flat surfaces. Since longitudinal chromatic aberration is color dependent, each row of the sensor array must follow a different non-planar focal surface, each surface for a particular color.

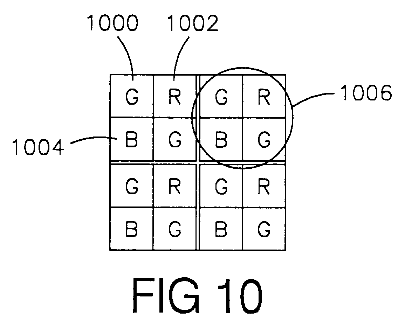

Figure 10 illustrates a portion of a photosensor array in which the elements are arranged into a matrix, representative of the types of photosensor arrays used in cameras. Elements with the letter "G" (1000) receive green light. Elements with the letter "R" (1002) receive red light. Elements with the letter "B" (1004) receive blue light. A picture element (pixel) is defined by a cluster of four individual elements as indicated by circle 1006. When sensor elements are mixed within rows and columns as illustrated in figure 10, modifying X,Y position to compensate for distortion and chromatic aberration becomes a problem, possibly requiring increasing the spacing between sensor elements and thereby reducing resolution. However, compensation for field curvature and longitudinal (or axial) chromatic aberration may be implemented for a matrix array in the same manner as illustrated in figure 9. The red sensors lay along one three dimensional focal surface (for example, figure 2, surface 210), the blue sensors lay along a second three dimensional focal surface (for example, figure 2, surface 212), and the green sensors lay along a third three dimensional focal surface.

The foregoing description of the present invention has been presented for purposes of illustration and description. It is not intended to be exhaustive or to limit the invention to the precise form disclosed, and other modifications and variations may be possible in light of the above teachings. The embodiment was chosen and described in order to best explain the principles of the invention and its practical application to thereby enable others skilled in the art to best utilize the invention in various embodiments and various modifications as are suited to the particular use contemplated. It is intended that the appended claims be construed to include other alternative embodiments of the invention except insofar as limited by the prior art.

## Claims

1. A photosensor array (800, 802, 804) for use with an optical system (200, 300, 400), wherein when an image having uniform intensity is imaged by the optical system onto the photosensor array, the image on the photosensor array has a non-uniform intensity, the photosensor array further comprising:
each sensor element having an active area, the active area being inversely proportional to the intensity of the projection of the uniform intensity impinging onto the sensor element.

2. A photosensor array (800, 802, 804) for use with an optical system (200, 300, 400), the optical system further comprising an illumination source having non-uniform intensity, light from the illumination source being imaged by the optical system onto the photosensor array, the photosensor array further comprising:
each sensor element having an active area, the active area being inversely proportional to the intensity of the projection of the illumination source impinging onto the sensor element.
